# EUROPÄISCHE PATENTSCHRIFT

(11) **EP 4 589 309 B1**
(45) Veröffentlichungstag und Bekanntmachung des Hinweises auf die Patenterteilung: **03.12.2025**
(21) Anmeldenummer: 24153119.3
(22) Anmeldetag: 22.01.2024
(51) Int. Cl.: G01R 19/25, G01R 21/00, G01R 22/06, H01R 13/66

(54) **MESSENDE STECKDOSE**
METERING SOCKET
PRISE DE MESURE

(43) Veröffentlichungstag der Anmeldung: 23.07.2025
(73) Patentinhaber: Insta GmbH, 58509 Lüdenscheid (DE); Albrecht Jung GmbH & Co. KG, 58579 Schalksmühle (DE)
(72) Erfinder: Biniossek, Nik, 58099 Hagen (DE); Era, Eduard, 58513 Lüdenscheid (DE); Becker-Hennecke, Ralph, 58239 Schwerte (DE)

(56) Entgegenhaltungen:
- DE-U1- 202022 106 389
- SCHNEIDER ELECTRIC GMBH: "Installationsanleitung Connected SCHUKO-Steckdose 16A", 1 August 2021 (2021-08-01), Website of Schneider Electric GmbH c/o Merten, pages 1 - 2, XP093134460, Retrieved from the Internet <URL:https://www.productinfo.schneider-electric.com/wiser_home/sysm_sysd-connected-single-socket-outlet-16-a-wiser_home_device-user-guide/German/SysM_SysD%20-%20Connected%20Single%20Socket%20Outlet%2016%20A_Wiser_Home_Device%20User%20Guide_de_0000783406.xml/$/WHM-Connectedsinglesocketoutlet16A-Installing> [retrieved on 20240223]

## Beschreibung

Die Erfindung betrifft eine messende Steckdose zur Energie- und/oder Leistungsmessung bezüglich einer an die Steckdose angeschlossenen Last, umfassend jeweils mindestens zwei Anschlussmittel für einen Außenleiter, einen Neutralleiter und einen Schutzleiter, die an einen Außenleiterkontakt, den Neutralleiterkontakt und den Schutzleiterkontakt des Klemmblocks des Sockels der Steckdose angeschlossen sind, sowie ferner umfassend eine auf einer Leiterplatte angeordneten Energie- und/oder Leistungsmessungseinrichtung sowie eine Sendeeinheit zum Übersenden der durch die Energie- und/oder Leistungsmessung erhaltenen Daten an eine Auswerteeinheit, wobei ein Einzelanschlussmittel für einen Außenleiter den Außenleiter zur Bildung einer Messbrücke nach der Energie- und/oder Leistungsmessungseinrichtung kontaktiert, so dass die Energie- und/oder Leistungsmessungseinrichtung über die Messbrücke weitere an die messende Steckdose angeschlossene Lasten desselben Lastkreises hinsichtlich der Energie- und/oder Leistungsmessung erfassbar macht.

Messende Steckdosen, die sowohl eine Energie- als auch eine Leistungsmessung über eine Energie- und oder Leistungsmessungseinrichtung ermöglichen, sind kürzlich ebenfalls bekannt geworden: *www.jung-group.com*/*de-DE*/*JUNG-HOME-SCHUKO-Steckdose-Energy-Safety-alpinweiss*/*BT-LS-1521-SE-WW und www.merten.de*/*produkt*/*meg2380-0319-connected-schuko-steckdose-16a-system-m-thermoplast-brillant-polarweiss-glaenzend.html#tab-specifications.* Solche Steckdosen erlauben es zudem, angeschlossene Verbraucher zu schalten und die erfasste Energie- und/oder Leistungsmessung an eine zentrale Auswerteeinheit zu übersenden, so dass eine Auswertung und Visulisierung hinsichtlich der Energie- und/oder Leistungsdaten möglich wird. Problematisch bei derartigen Steckdosen ist jedoch, dass die Energie- und/oder Leistungsmessung nur für die Last möglich ist, die an die messende Steckdose angeschlossen ist. Insbesondere erlaubt eine solche messende Steckdose keine Auswertung einer benachbarten, ebenfalls an den Lastkreis der messenden Steckdose angeschlossenen, nicht messenden Steckdose, obwohl die benachbarte Steckdose über eine Brücke, realisiert über ein Anschlussmittel für einen Außenleiter, einen Neutralleiter und einen Schutzleiter, vor der Energie- und/oder Leistungsmessungseinrichtung, an denselben Lastkreis angeschlossen ist. Vielmehr ist der kostspielige Verbau einer weiteren messenden Steckdose vorzusehen. Auch wird dadurch die Erfassung von weiteren Verbrauchern, die an denselben Lastkreis (regelmäßig weist ein Raum einen Lastkreis auf) angeschlossen und keine Steckdose sind, also: Jalousieaktoren, Lampen oder dergleichen, unmöglich, da ein Austausch von Licht- oder Jalousieschaltern durch messende Steckdosen mit einer Änderung der Funktionalität einhergeht.

Daher ist unter DE 2020 221 06 389 U1 eine gattungsgemäße messende Steckdose gemäß des Oberbegriffs des Anspruchs 1 bekannt geworden, wobei auf vorteilhafte Weise ein Einzelanschlussmittel für einen Außenleiter den Außenleiter zur Bildung einer Messbrücke nach der Energie- und/oder Leistungsmessungseinrichtung kontaktiert, so dass die Energie- und/oder Leistungsmessungseinrichtung über die Messbrücke weitere an die messende Steckdose angeschlossene Lasten desselben Lastkreises hinsichtlich der Energie- und/oder Leistungsmessung erfassbar macht.

Besonders nachteilig bei der vorstehenden Lösung ist jedoch, dass das zur Realisierung einer Messbrücke erforderliche zusätzliche Einzelanschlussmittel eine vollständig neue Gestaltung des Klemmblocks des Sockels erfordert, wobei der Sockel mit bereits sechs Anschlussmitteln bauraumtechnisch bereits an der Grenze des platztechnisch Machbaren liegt.

Ausgehend von diesem diskutierten Stand der Technik liegt der Erfindung die Aufgabe zugrunde, eine messende Steckdose zur Energie- und/oder Leistungsmessung bezüglich einer an die Steckdose angeschlossenen Last zu schaffen, die es erlaubt, weitere elektrische Verbraucher, insbesondere Steckdosen, Leuchten oder Jalousieaktoren, die an denselben Lastkreis angeschlossen sind, bezüglich der Energie- und/oder Leistungsaufnahme zu erfassen, ohne eine weitere messende Steckdose zur Energie- und/oder Leistungsmessung mit einer entsprechenden Energie- und oder Leistungsmessungseinrichtung an die Steckdose anzuschließen, wobei der Klemmblock des Sockels der Steckdose lediglich sechs Anschlussmittel (Steck- oder Schraubklemmen) aufweist.

Gelöst wird diese Aufgabe durch eine messende Steckdose gemäß Hauptanspruch 1.

Bei der Erfindung wird durch Kontaktierung des Außenleiters eine Messbrücke geschaffen, die über die Energie- und/oder Leistungsmessungseinrichtung dank der Messbrücke weitere an die messende Steckdose angeschlossene Lasten desselben Lastkreises hinsichtlich der Energie- und/oder Leistungsmessung erfassbar macht. Hierzu ist bei der erfindungsgemäßen messenden Steckdose zur Bildung einer Messbrücke ein Einzelanschlussmittel für einen Außenleiter vorgesehen, wobei das Einzelanschlussmittel, beispielsweise eine Schraubklemme, den Außenleiter zur Bildung einer Messbrücke nach der Energie- und/oder Leistungsmessungseinrichtung kontaktiert. Besonders geschickt wird dieses erfindungsgemäß jedoch realisiert, ohne dass der Klemmblock der Steckdose dieses Einzelanschlussmittel aufweist. Vielmehr wird bei der erfindungsgemäßen messenden Steckdose auf intelligente Art und Weise die Anordnung des Einzelanschlussmittels und des Klemmblocks so gewählt, dass das Einzelanschlussmittel und der Klemmblock auf unterschiedlichen Seiten der Leiterplatte angeordnet sind. Das Einzelanschlussmittel und der Klemmblock werden damit durch die Leiterplatte voneinander getrennt, wobei der Klemmblock nicht auf der Leiterplatte angeordnet sein muss, jedoch auf der anderen Seite der Leiterplatte angeordnet ist als das Einzelanschlussmittel. Damit kann nicht nur von einer Überarbeitung des Klemmblocks (Erweiterung der mindestens sechs Anschlussmittel um das Einzelanschlussmittel) abgesehen werden, um die Messbrücke zu realisieren, sondern wird gleichzeitig die Zugänglichkeit des Einzelanschlussmittels zum Anschließen eines Außenleiters zur Realisierung der Messbrücke substanziell verbessert, da die Anzahl der Anschlusskabel, die nebeneinander am Klemmblock anzuschließen sind, abgesenkt wird. Ein erfindungsgemäßes Einzelanschlussmittel kann auch dazu genutzt werden, mehr als einen Außenleiter zur Realisierung der Messbrücke anzuschließen.

Grundsätzlich umfasst eine solche messende Steckdose zur Energie- und/oder Leistungsmessung bezüglich einer an die Steckdose angeschlossenen Last jeweils mindestens zwei Anschlussmittel für einen Außenleiter, einen Neutralleiter und einen Schutzleiter, die an einen Außenleiterkontakt, den Neutralleiterkontakt und den Schutzleiterkontakt der Steckdose angeschlossen sind. Die jeweils zwei Anschlussmittel sind daher vorzusehen, da ein Anschlussmittel als Eingang und das andere als Ausgang dient.

Damit eine solche messende Steckdose eine Energie- und/oder Leistungsmessung vornehmen kann, umfasst sie ferner eine Energie- und/oder Leistungsmessungseinrichtung. Zur Ermöglichung der Auswertung der erfassten Energie- und/oder Leistungsdaten in einer Auswerteeinheit, umfasst die messende Steckdose eine Sendeeinheit zum Übersenden der durch die Energie- und/oder Leistungsmessung erhaltenen Daten an die Auswerteeinheit.

Vorteilhaft bei der erfindungsgemäßen messenden Steckdose ist, dass die bereits im Lastkreis befindliche Verkabelung vollständig erhalten bleibt und sich für den Anwender überhaupt keine Abweichungen ergeben. Vielmehr wird die vorhandene Brücke in eine Messbrücke umgewandelt, indem die erfindungsgemäße messende Steckdose statt einer vorbekannten messenden Steckdose genutzt wird. Neben der Ermöglichung weiterer über die Messbrücke an die messende Steckdose angeschlossener Lasten desselben Lastkreises hinsichtlich der Energie- und/oder Leistungsmessung stellt der Erhalt der existierenden Verkabelung einen spürbaren Vorteil da, der die Installationshürde der erfindungsgemäßen messenden Steckdose nicht anhebt - jedoch weitere Messfunktionalitäten ermöglicht und den Verbau weiterer messender Steckdosen und damit erheblichen Zusatzaufwand und signifikante Zusatzkosten vermeidet.

Gemäß einer besonders bevorzugten Ausgestaltung der Erfindung ist das Einzelanschlussmittel als Schraubklemme ausgeführt. Diese Schraubklemme ist bevorzugt so ausgeführt, dass die Längsachse der Schraube der Schraubklemme parallel zur Ebene der Leiterplatte verläuft. Damit wird der Bauraumbedarf weiter verringert.

Gemäß einer besonders bevorzugten Weiterbildung der erfindungsgemäßen messenden Steckdose umfasst diese ein einkanaliges, ein Schaltelement aufweisendes, Relais. Hierdurch kann vorteilhafterweise zusätzlich zu der eigentlichen Messfunktionalität auch eine Schaltfunktionalität implementiert werden. Aufgrund der Steuerbarkeit über eine Fernbedienung ergibt sich für beide Funktionalitäten ein besonderer Bedienkomfort.

In einer alternativen besonders bevorzugten Weiterbildung der erfindungsgemäßen messenden Steckdose umfasst diese ein zweikanaliges, zwei Schaltelemente aufweisendes, Relais, welches über eine Fernbedienung steuerbar ist. Dabei ist ein Schaltelement in den die Messbrücke realisierenden Außenleiter integriert, so dass auch über die Messbrücke weitere an die messende Steckdose angeschlossene Lasten desselben Lastkreises schaltbar gemacht werden. Insofern kann sowohl die an die messende Steckdose angeschlossene Last als auch weitere an die messende Steckdose angeschlossene Lasten desselben Lastkreises geschaltet werden. Damit wird der durch die Erfindung erreichte Vorteil von der Messfunktionalität zur Energie- und/oder Leistungsmessung vorteilhafterweise auf das Schalten von Lasten desselben Lastkreises erweitert.

Gemäß einer Weiterbildung der erfindungsgemäßen messenden Steckdose weist diese ein Betätigungselement zur Vor-Ort-Betätigung auf, durch das die Energie- und/oder Leistungsmessungseinrichtung und/oder ein Relais gesteuert, insbesondere ein- oder ausgeschaltet, werden kann. Gemäß einer Weiterbildung der erfindungsgemäßen messenden Steckdose ist das Einzelanschlussmittel weniger als 10 mm vom Rand der Leiterplatte angeordnet. Dadurch wird nicht nur der Platzbedarf für ein Relais auf der Leiterplatte eingehalten, sondern ist die Zugänglichkeit des Einzelanschlussmittels für einen anzuschließenden Außenleiter besonders gut.

Nachfolgend ist die Erfindung unter Bezugnahme auf die beigefügten Figuren anhand diverser Ausführungsbeispiele beschrieben. Es zeigen:
- **Fig. 1:**: eine schematische Darstellung einer erfindungsgemäßen messenden Steckdose,
- **Fig. 2:**: eine schematische Darstellung einer erfindungsgemäßen messenden Steckdose, die über einen Außenleiter zur Bildung einer Messbrücke an zwei weitere nicht messende Steckdosen desselben Lastkreises angeschlossen ist, wodurch ein erfindungsgemäßes Netzwerk von elektrischen/elektronischen Installationsgeräten realisiert wird,
- **Fig. 3:**: eine perspektivische Darstellung einer erfindungsgemäßen messenden Steckdose in einer Explosionsdarstellung, und
- **Fig. 4:**: eine perspektivische Darstellung einer erfindungsgemäßen messenden Steckdose mit (links) und ohne (rechts) Gehäusedeckel.

In den verschiedenen Figuren sind gleiche Teile stets mit den gleichen Bezugszeichen versehen und werden daher in der Regel auch jeweils nur einmal benannt beziehungsweise erwähnt.

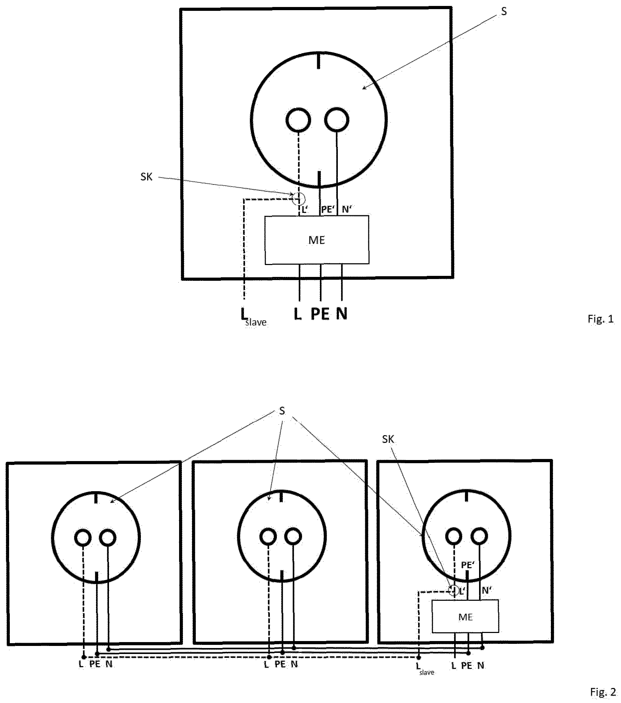

Bei der in Figur 1 gezeigten erfindungsgemäßen messenden Steckdose S, ist neben den mindestens zwei Anschlussmitteln für einen Außenleiter L, einen Neutralleiter N und einen Schutzleiter PE, (also insgesamt sechs) ein Einzelanschlussmittel SK für einen Außenleiter L vorgesehen, das den Außenleiter L zur Bildung einer Messbrücke Lₛₗₐᵥₑ nach der Energie- und/oder Leistungsmessungseinrichtung ME kontaktiert. Dieses erlaubt es, dass die Energie- und/oder Leistungsmessungseinrichtung ME über die Messbrücke Lₛₗₐᵥₑ weitere an die messende Steckdose S angeschlossene Lasten desselben Lastkreises hinsichtlich der Energie- und/oder Leistungsmessung erfassbar macht. In einer (nicht dargestellten) Weiterbildung der erfindungsgemäßen messenden Steckdose S weist diese ein Betätigungselement zur Vor-Ort-Betätigung auf, durch das die Energie- und/oder Leistungsmessungseinrichtung ME und/oder ein Relais R gesteuert, insbesondere ein- oder ausgeschaltet, werden kann. Die erfindungsgemäße Steckdose S umfasst zudem eine der Übersichtlichkeit halber nicht dargestellte Sendeeinheit zum Übersenden der durch die Energie- und/oder Leistungsmessung ME erhaltenen Daten an eine Auswerteeinheit, beispielsweise eines Endgerätes.

Dieser Umstand ist in Figur 2 visualisiert, die eine schematische Darstellung einer erfindungsgemäßen messenden Steckdose S zeigt, die über einen Außenleiter L zur Bildung einer Messbrücke Lₛₗₐᵥₑ an zwei weitere nicht messende Steckdosen S desselben Lastkreises angeschlossen ist.

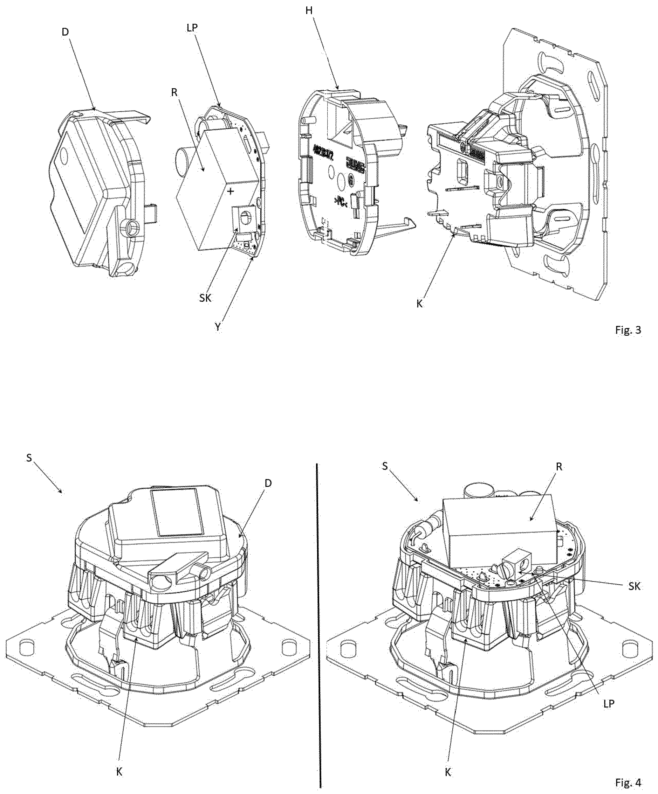

Figur 3 zeigt eine perspektivische Darstellung einer erfindungsgemäßen messenden Steckdose S in einer Explosionsdarstellung. Das Einzelanschlussmittel SK und der Klemmblock K der Steckdose S sind erfindungsgemäß auf unterschiedlichen Seiten der Leiterplatte LP angeordnet.

Dabei ist erkennbar, dass die Leiterplatte LP über einen Halter H an den Sockel angeschlossen ist und einen Rand Y aufweist. Dabei ist das Einzelanschlussmittel SK als Schraubklemme ausgeführt und weist einen bauraumeffizienten Maximalabstand vom Rand Y von weniger als 10 mm auf. Damit wird ausreichend Platz zur Anordnung eines Relais R auf der Leiterplatte LP geschaffen. Das Relais R, die Leiterplatte LP und das Einzelanschlussmittel SK sind durch einen Gehäusedeckel D abdeckbar.

Figur 4 zeigt eine perspektivische Darstellung der erfindungsgemäßen messenden Steckdose mit (links) und ohne (rechts) einen solchen Gehäusedeckel D. Ein solcher Gehäusedeckel weist zwei Öffnungen auf, eine für einen die Messbrücke Lₛₗₐᵥₑ realisierenden Leiter und eine für einen Schraubendreher, um den Leiter festzuklemmen.

Die Erfindung ist anhand von Ausführungsbeispielen beschrieben. Ohne den Umfang der geltenden Ansprüche zu verlassen, ergeben sich für einen Fachmann zahlreiche weitere Möglichkeiten, diese umzusetzen, ohne dass dieses im Rahmen dieser Ausführungen im Einzelnen erläutert werden müsste.

### Bezugszeichenliste

- D: Gehäusedeckel
- H: Halter
- K: Klemmblock
- L, L': Außenleiter
- Lₛₗₐᵥₑ: Messbrücke
- LP: Leiterplatte
- ME: Energie- und/oder Leistungsmessungseinrichtung
- N, N': Neutralleiter
- PE, PE': Schutzleiter
- R: Relais
- S: Steckdose
- SK: Einzelanschlussmittel
- Y: Rand

## Patentansprüche

1. Messende Steckdose zur Energie- und/oder Leistungsmessung bezüglich einer an die Steckdose (S) angeschlossenen Last, umfassend jeweils mindestens zwei Anschlussmittel für einen Außenleiter (L), einen Neutralleiter (N) und einen Schutzleiter (PE), die an einen Außenleiterkontakt, einen Neutralleiterkontakt und einen Schutzleiterkontakt eines Klemmblocks (K) eines Sockels der Steckdose (S) angeschlossen sind, sowie ferner umfassend eine auf einer Leiterplatte (LP) angeordneten Energie- und/oder Leistungsmessungseinrichtung (ME), sowie eine Sendeeinheit zum Übersenden der durch die Energie- und/oder Leistungsmessung erhaltenen Daten an eine Auswerteeinheit, wobei ein Einzelanschlussmittel (SK) für einen Außenleiter (L) dazu eingerichtet ist, den Außenleiter (L) zur Bildung einer Messbrücke (Lₛₗₐᵥₑ) nach der Energie- und/oder Leistungsmessungseinrichtung (ME) zu kontaktieren, so dass die Energie- und/oder Leistungsmessungseinrichtung (ME) über die Messbrücke (Lₛₗₐᵥₑ) weitere an die messende Steckdose (S) angeschlossene Lasten desselben Lastkreises hinsichtlich der Energie- und/oder Leistungsmessung erfassbar macht, **dadurch gekennzeichnet, dass** das Einzelanschlussmittel (SK) und der Klemmblock (K) auf unterschiedlichen Seiten der Leiterplatte (LP) angeordnet sind, wobei das Einzelanschlussmittel (SK) dazu eingerichtet ist, den Außenleiter (L) zwischen einer Steckdosenbuchse und der Energie- und/oder Leistungsmessungseinrichtung (ME) zu kontaktieren.

2. Steckdose nach Anspruch 1, **dadurch gekennzeichnet, dass** das Einzelanschlussmittel (SK) als Schraubklemme ausgeführt ist.

3. Steckdose nach Anspruch 1 oder 2, **dadurch gekennzeichnet, dass** die Steckdose (S) ein einkanaliges, ein Schaltelement aufweisendes, Relais (R) umfasst, welches über eine Fernbedienung steuerbar ist.

4. Steckdose nach Anspruch 1 oder 2, **dadurch gekennzeichnet, dass** die Steckdose ein zweikanaliges, zwei Schaltelemente aufweisendes, Relais umfasst, welches über eine Fernbedienung steuerbar ist, wobei ein Schaltelement in den die Messbrücke (Lₛₗₐᵥₑ) realisierenden Außenleiter integriert ist, so dass auch über die Messbrücke weitere an die messende Steckdose (S) angeschlossene Lasten desselben Lastkreises schaltbar gemacht werden.

5. Steckdose nach einem der Ansprüche 1 bis 4, **dadurch gekennzeichnet, dass** das Einzelanschlussmittel (SK) weniger als 10 mm vom Rand (Y) der Leiterplatte (LP) angeordnet ist.

6. Steckdose nach einem der Ansprüche 1 bis 5, **dadurch gekennzeichnet, dass** die Steckdose (S) ein Betätigungselement zur Vor-Ort-Betätigung aufweist, durch das die Energie- und/oder Leistungsmessungseinrichtung (ME) und/oder ein Relais gesteuert, insbesondere ein- oder ausgeschaltet, werden kann.

7. Steckdose nach einem der Ansprüche 1 bis 6, **dadurch gekennzeichnet, dass** die Leiterplatte (LP) über einen Halter (H) an den Sockel angeschlossen ist.

8. Steckdose nach einem der Ansprüche 2 bis 6, **dadurch gekennzeichnet, dass** die Schraubklemme so ausgeführt ist, dass die Längsachse der Schraube der Schraubklemme parallel zur Ebene der Leiterplatte (LP) verläuft.

## Claims

1. Measuring socket for measuring energy and/or power in relation to a load connected to the socket (S), comprising at least two connection means each for an outer conductor (L), a neutral conductor (N) and a protective conductor (PE), which are connected to an outer conductor contact, a neutral conductor contact and a protective conductor contact of a terminal block (K) of a socket base (S), and further comprising an energy and/or power measuring device (ME) arranged on a printed circuit board (LP), and a transmission unit for transmitting the data obtained by the energy and/or power measurement to an evaluation unit, wherein a single connection means (SK) for an outer conductor (L) is designed to connect the outer conductor (L) to form a measuring bridge (Lₛₗₐᵥₑ) downstream of the energy and/or power measurement device (ME), so that the energy and/or power measurement device (ME) can detect further loads of the same load circuit connected to the measuring socket (S) via the measuring bridge (Lₛₗₐᵥₑ) for the purpose of energy and/or power measurement, **characterised in that** the individual connection means (SK) and the terminal block (K) are arranged on different sides of the printed circuit board (LP), wherein the individual connection means (SK) is designed to contact the outer conductor (L) between a socket outlet and the energy and/or power measurement device (ME).

2. Socket according to claim 1, **characterised in that** the single connection means (SK) is designed as a screw terminal.

3. Socket according to claim 1 or 2, **characterised in that** the socket (S) comprises a single-channel relay (R) having a switching element, which relay can be controlled via a remote control.

4. Socket according to claim 1 or 2, **characterised in that** the socket comprises a two-channel relay with two switching elements, which relay can be controlled via a remote control, wherein one switching element is integrated into the outer conductor forming the measuring bridge (Lₛₗₐᵥₑ), so that other loads of the same load circuit connected to the measuring socket (S) can also be switched via the measuring bridge.

5. Socket according to any of claims 1 to 4, **characterised in that** the single connection means (SK) is arranged less than 10 mm from the edge (Y) of the printed circuit board (LP).

6. Socket according to any of claims 1 to 5, **characterised in that** the socket (S) has an actuating element for on-site actuation, by means of which the energy and/or power measuring device (ME) and/or a relay can be controlled, in particular switched on or off.

7. Socket according to any of claims 1 to 6, **characterised in that** the printed circuit board (LP) is connected to the base via a holder (H).

8. Socket according to any of claims 2 to 6, **characterised in that** the screw terminal is designed such that the longitudinal axis of the screw of the screw terminal runs parallel to the plane of the printed circuit board (LP).

## Revendications

1. Prise de mesure pour mesurer l'énergie et/ou la puissance relative à une charge connectée à la prise (S), comprenant au moins deux moyens de connexion chacun pour un conducteur extérieur (L), un conducteur neutre (N) et un conducteur de protection (PE), qui sont raccordés à un contact de conducteur extérieur, à un contact de conducteur neutre et à un contact de conducteur de protection d'un répartiteur (K) d'un socle de la prise (S), et comprenant en outre un dispositif de mesure d'énergie et/ou de puissance (ME) disposé sur une carte de circuit imprimé (LP), ainsi qu'une unité de transmission pour transmettre les données obtenues par la mesure d'énergie et/ou de puissance à une unité d'évaluation, un moyen de connexion individuel (SK) pour un conducteur extérieur (L) étant conçu pour connecter le conducteur extérieur (L) pour former un pont de mesure (Lₛₗₐᵥₑ) en aval du dispositif de mesure d'énergie et/ou de puissance (ME), de sorte que le dispositif de mesure d'énergie et/ou de puissance (ME) puisse, via le pont de mesure (Lₛₗₐᵥₑ), détecter d'autres charges du même circuit de charge raccordées à la prise de mesure (S) en vue de la mesure d'énergie et/ou de puissance, **caractérisé en ce que** le moyen de connexion individuel (SK) et le répartiteur (K) sont disposés sur des côtés différents de la carte de circuit imprimé (LP), le moyen de connexion individuel (SK) étant conçu pour mettre en contact le conducteur extérieur (L) entre une prise de courant et le dispositif de mesure d'énergie et/ou de puissance (ME).

2. Prise électrique selon la revendication 1, **caractérisée en ce que** le moyen de connexion individuel (SK) est conçu comme une borne à vis.

3. Prise électrique selon la revendication 1 ou 2, **caractérisée en ce que** la prise électrique (S) comprend un relais (R) à canal unique comportant un élément de commutation, ce relais pouvant être commandé à distance.

4. Prise selon la revendication 1 ou 2, **caractérisée en ce que** la prise comprend un relais à deux canaux comportant deux éléments de commutation, lequel relais peut être commandé à distance, un élément de commutation étant intégré dans le conducteur extérieur réalisant le pont de mesure (Lₛₗₐᵥₑ), de sorte que d'autres charges du même circuit de charge raccordées à la prise de mesure (S) peuvent également être commutées via le pont de mesure.

5. Prise électrique selon l'une quelconque des revendications 1 à 4, **caractérisée en ce que** le moyen de connexion individuel (SK) est disposé à moins de 10 mm du bord (Y) de la carte de circuit imprimé (LP).

6. Prise électrique selon l'une quelconque des revendications 1 à 5, **caractérisée en ce que** la prise électrique (S) comporte un élément d'actionnement pour l'actionnement sur place, grâce auquel le dispositif de mesure d'énergie et/ou de puissance (ME) et/ou un relais peuvent être commandés, en particulier activés ou désactivés.

7. Prise électrique selon l'une quelconque des revendications 1 à 6, **caractérisée en ce que** la carte de circuit imprimé (LP) est reliée au socle par l'intermédiaire d'un support (H).

8. Prise électrique selon l'une quelconque des revendications 2 à 6, **caractérisée en ce que** la borne à vis est conçue de telle sorte que l'axe longitudinal de la vis de la borne à vis s'étend parallèlement au plan de la carte de circuit imprimé (LP).
